# EUROPEAN PATENT APPLICATION

(11) **EP 2 712 048 A2**
(43) Date of publication of application: **26.03.2014**
(21) Application number: 11777293.9
(22) Date of filing: 29.07.2011
(51) Int. Cl.: H02J 7/32, H04W 88/02

(54) **ULTRA-LONG STANDBY METHOD AND ULTRA-LONG STANDBY TERMINAL**

(71) Applicant: Huawei Device Co., Ltd., Shenzhen, Guangdong 518129 (CN)
(72) Inventor: PAN, Yajun, Guangdong 518129 (CN)
(74) Representative: Maiwald Patentanwalts GmbH
(86) International application number: PCT/CN2011/077804
(87) International publication number: WO 2011/137874

(57) **Abstract**

An ultra-long standby method and an ultra-long standby terminal are provided in embodiments of the present invention. The method: disposes a solar power supply apparatus on a terminal and disposes an analog switch between the solar power supply apparatus and a battery within the terminal, where the solar power supply apparatus and the battery form two input paths of an output circuit, the output circuit supplies power to a preset module, and the preset module is a module that matches a power supply voltage and a solar input voltage; detects whether or not the solar power supply apparatus continues to convert electrical energy; and controls, upon detecting that the solar power supply apparatus continues to convert electrical energy, the analog switch to switch the input paths to the solar power supply apparatus so that the solar power supply apparatus supplies power to the preset module. Therefore, solar energy can be used to implement ultra-long standby for a terminal, significantly improving user experience.

## Description

### TECHNICAL FIELD

The present invention relates to the field of terminal devices, and in particular to, an ultra-long standby method and an ultra-long standby terminal.

### BACKGROUND

Currently, as the photovoltaic industry is growing rapidly, the solar cells that are based on crystalline silicon are dominating the photovoltaic market, and enjoy a market share of more than 90%. At present, the solar technology has been widely used in devices such as water heaters, street lamps, and mobile phones.

Currently, for applications of the solar technology on terminal, for example mobile phones, three application schemes are available: 1. mobile phones with solar panels; 2. mobile phones with solar expansion slots; 3. mobile phones that are recharged by directly using solar chargers.

In the solutions according to the prior art, however, the solar conversion rate is only about 15% now in the industry, which becomes a bottleneck for applications in portable terminal products; the normal recharging temperature for a common lithium-ion battery is 0 to 45 degrees Celsius. If a terminal is solar recharged by exposure under the sun, the surface temperature of the terminal rises (under strong sunlight radiation, the surface temperature may reach up to 60 to 70 degrees Celsius), resulting in a large impact on the lithium-ion battery performance. The capacity of the lithium-ion battery attenuates, shortening the standby time of the terminal and affecting user experience.

### SUMMARY

The purpose of the present invention is to provide an ultra-long standby method and an ultra-long standby terminal that are able to use solar energy to implement ultra-long standby for a terminal, thereby significantly improving user experience.

An ultra-long standby method is provided, including:
disposing a solar power supply apparatus on a terminal and disposing an analog switch between the solar power supply apparatus and a battery within the terminal, where the solar power supply apparatus and the battery form two input paths of an output circuit, the output circuit supplies power to a preset module, and the preset module is a module that matches a power supply voltage and a solar input voltage;
detecting whether or not the solar power supply apparatus continues to convert electrical energy; and
controlling, upon detecting that the solar power supply apparatus continues to convert electrical energy, the analog switch to switch the input paths to the solar power supply apparatus so that the solar power supply apparatus supplies power to the preset module.

An ultra-long standby terminal is provided, including:
a solar power supply apparatus disposed on a terminal, configured to supply power to a terminal module that matches a power supply voltage and a solar input voltage;
an analog switch, disposed between the solar power supply apparatus and a battery within the terminal; where, the solar power supply apparatus and the battery form two input paths of an output circuit, the output circuit supplies power to a preset module, and the preset module is a module that matches a power supply voltage and a solar input voltage;
a detecting unit, configured to detect whether or not the solar power supply apparatus continues to convert electrical energy; and
a path switching unit, configured to control, when the detecting unit detects that the solar power supply apparatus continues to convert electrical energy, the analog switch to switch the input paths to the solar power supply apparatus so that the solar power supply apparatus supplies power to the preset module.

From the provided technical solutions, it may be seen that, the mehod: disposes a solar power supply apparatus on a terminal and disposesan analog switch between the solar power supply apparatus and a battery within the terminal, where the solar power supply apparatus and the battery form two input paths of an output circuit, the output circuit supplies power to a preset module, and the preset module is a module that matches a power supply voltage and a solar input voltage; detects whether or not the solar power supply apparatus continues to convert electrical energy; and controls, upon detecting that the solar power supply apparatus continues to convert electrical energy, the analog switch to switch the input paths to the solar power supply apparatus so that the solar power supply apparatus supplies power to the preset module, thereby using solar energy to implementing ultra-long standby for a terminal, and significantly improving user experience.

### BRIEF DESCRIPTION OF THE DRAWINGS

FIG. 1 is a schematic flowchart of an ultra-long standby method according to an embodiment of the present invention;
FIG. 2 is a structural schematic diagram of a system where only a battery is used for supplying power in a specific example according to an embodiment of the present invention;
FIG. 3 is a structural schematic diagram of a system for implementing ultra-long standby in a specific example according to an embodiment of the present invention; and
FIG. 4 is a structural schematic diagram of an ultra-long standby terminal according to an embodiment of the present invention.

### DESCRIPTION OF EMBODIMENTS

Embodiments of the present invention provide an ultra-long standby method and an ultra-long standby terminal, where specifically solar energy is used as an auxiliary power supply source in addition to the battery of a terminal, minimizing consumption of the battery in various applications of the terminal, thereby indirectly implementing ultra-long standby for the terminal, and significantly improving user experience.

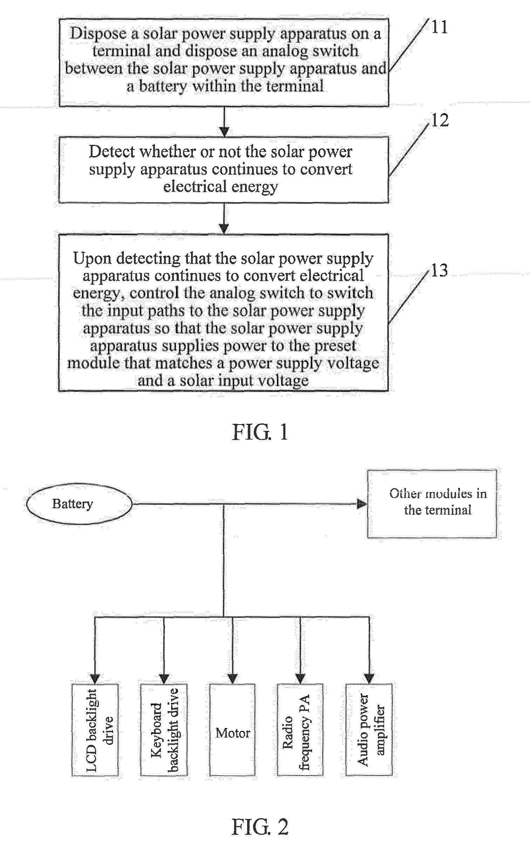

To better describe the embodiments of the present invention, the following describes a specific implementation manner of the present invention with reference to drawings. FIG. 1 is a schematic flowchart of an ultra-long standby method according to an embodiment of the present invention. The method includes:

Step 11: Dispose a solar power supply apparatus on a terminal and dispose an analog switch between the solar power supply apparatus and a battery within the terminal.

In this step, the solar power supply apparatus may be formed by a solar panel and a photoelectric conversion module, and may be disposed on a rear side of the terminal. During the specific implementation process, the solar power supply apparatus may also be disposed in another position of the terminal; the solar panel and photoelectric conversion module may be implemented by common means in the prior art, which is not limited herein.

For the disposed analog switch, the battery and the solar power supply apparatus form two input paths of an output circuit, the output circuit supplies power to a preset module in the terminal, and another output circuit formed by the battery still supplies power to other modules in the terminal. In this embodiment, the power of the system may be supplied by the input paths of the battery by default; of course, during the specific implementation process, the system may also be set to null by default, and switch to the input path for power supply according to the specific use condition.

The terminal may include: a mobile phone, tablet computer, or laptop computer, or may also include other terminal devices that use a battery to supply power.

Step 12: Detect whether or not the solar power supply apparatus continues to convert electrical energy.

In this step, a voltage detection apparatus may be used for detection. When the voltage detection apparatus detects that the solar power supply apparatus continues to generate voltage, it can be determined that the solar power supply apparatus continues to convert electrical energy.

Of course, during the specific implementation process, other detection apparatuses, for example, a current detection apparatus, may be used for implementation, which is not limited herein.

Step 13: Upon detecting that the solar power supply apparatus continues to convert electrical energy, control the analog switch to switch the input paths to the solar power supply apparatus so that the solar power supply apparatus supplies power to the preset module that matches a power supply voltage and a solar input voltage.

In this step, when it is detected by using the operation in step 12 that the solar power supply apparatus converts electrical energy, the analog switch may be controlled to switch the input paths to the solar power supply apparatus so that the solar power supply apparatus supplies power to the preset module that matches the power supply voltage and solar input voltage, whereas the terminal battery still supplies power to other modules in the terminal. In this manner, the consumption of the battery in various applications of the terminal is able to be minimized, thereby indirectly implementing ultra-long standby for the terminal.

During the specific implementation process, a method for controlling the analog switch may be sending a pulse signal to the analog switch to activate and control shutdown of the analog switch, thereby switching the input paths to the solar power supply apparatus so that the solar power supply apparatus supplies power to the module that matches the power supply voltage and solar input voltage.

The preset module that matches the power supply voltage and solar input voltage may include one or more of the following: screen backlight module, keyboard backlight module, radio frequency PA module, motor module, and audio power effect module. Specific selection of the modules may be classified according to requirements for the power supply voltage. Modules, for example, screen backlight module and keyboard backlight module, with high requirements are allocated to a group with high priority, and are preferentially powered by the solar power supply apparatus.

In addition, during the specific implementation process, the terminal is classified into a use state and a standby state. When the terminal is in the use state, the operation according to step 12 is performed; when the terminal is in the standby state, the analog switch may be further used to switch the solar power supply apparatus to the recharging path, and the recharging path is used to recharge the battery in the terminal, thereby further reducing consumption of the battery, and prolonging the terminal standby time. The method for determining that the terminal is in the use state or standby state may be by detecting whether the terminal is in screen lock; upon detecting that the terminal screen is locked, it may be further determined that the terminal is in the standby state. Of course, other methods that are able to determine that the terminal is in the use state or standby state in this field are also feasible, and are not limited in this embodiment.

The specific implementation means may be adding a branch to the analog switch, where the branch is connected to the recharging path; upon detecting that the terminal is in the standby state and is not used, another pulse signal may be sent to the analog switch to activate and control the analog switch to switch to the recharging path, so as to use this recharging path to recharge the battery in the terminal.

A solar implementation scheme on a mobile phone is used as an example. FIG. 2 is a structural schematic diagram of a system where only a battery is used for supplying power in the specific example. In FIG. 2, the battery supplies power to each component of the mobile phone, and all energy is consumed from here.

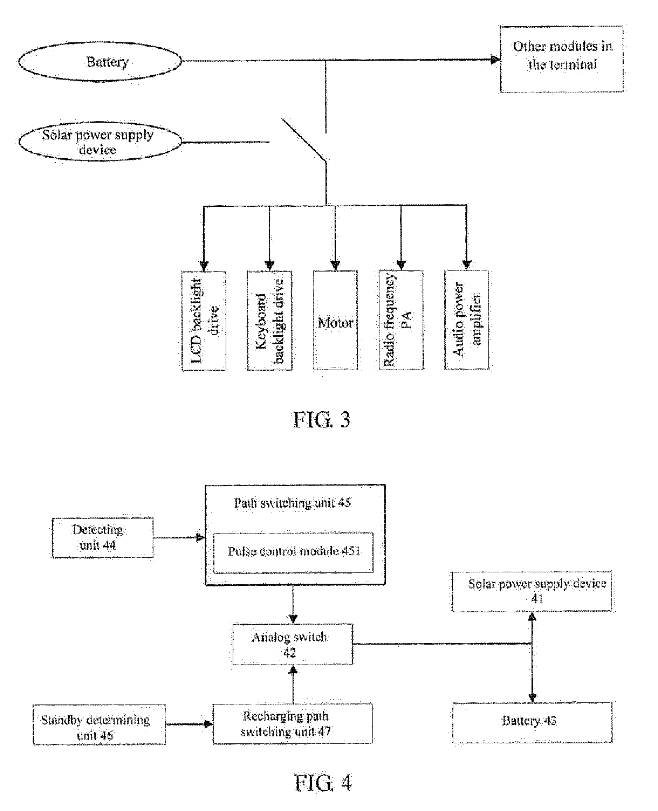

FIG. 3 is a structural schematic diagram of a system for implementing ultra-long standby in a specific example. In FIG. 3, a solar power supply apparatus is disposed on a rear side of a mobile phone, an analog switch is disposed between the mobile phone battery and the solar power supply apparatus, the battery and solar power supply apparatus form two input paths of an output circuit, the output circuit supplies power to a preset module in the terminal, and another output circuit formed by the battery still supplies power to other modules in the terminal. The system is disposed on a battery path by default, and the battery supplies power to each component.

When detecting that the solar power supply apparatus converts electrical energy, the general purpose input output (GPIO) of the system generates a pulse signal to control the analog switch to switch the input paths to the solar power supply apparatus so that the solar power supply apparatus supplies power to the module that matches the power supply voltage and solar input voltage. The module that matches the power supply voltage and solar input voltage may be an LCD backlight, keyboard backlight, radio frequency PA, or motor module.

In addition, according to how a user uses a mobile phone, in the scenario where the user normally uses the mobile phone outdoor: the solar power supply apparatus absorbs solar energy and converts it through a photoelectric conversion module into electrical energy for output, and the analog switch is controlled to switch the input paths to the solar power supply apparatus so that the solar power supply apparatus supplies power to the module that matches the power supply voltage and solar input voltage, reducing consumption of the battery.

In the scenario where the user does not use the mobile phone outdoor, that is, the mobile phone is in the standby state: the analog switch may be further used to switch the solar power supply apparatus to the recharging path, and the recharging path is used to recharge the battery in the terminal, thereby further reducing consumption of the battery and prolonging the terminal standby time.

An embodiment of the present invention further provides an ultra-long standby terminal. FIG. 4 is a structural schematic diagram of the ultra-long standby terminal according to the embodiment. The terminal includes:
a solar power supply apparatus 41 disposed on a terminal, configured to supply power to a terminal module that matches a power supply voltage and a solar input voltage;
an analog switch 42, disposed between a battery 43 within the terminal and the solar power supply apparatus 41; where, the battery 43 and the solar power supply apparatus 41 form two input paths of an output circuit, the output circuit supplies power to a preset module, and another output circuit formed by the battery 43 still supplies power to other modules in the terminal; for the specific implementation manner, refer to the description in step 11 of the foregoing method embodiment;
a detecting unit 44, configured to detect whether or not the solar power supply apparatus 41 continues to convert electrical energy; for the specific implementation manner, refer to the description in step 12 of the foregoing method embodiment; and
a path switching unit 45, configured to control, when the detecting unit 44 detects that the solar power supply apparatus 41 continues to convert electrical energy, the analog switch 42 to switch the input paths to the solar power supply apparatus 41 so that the solar power supply apparatus 41 supplies power to a module that matches a power supply voltage and a solar input voltage. For the specific implementation manner, refer to the description in step 13 of the foregoing method embodiment.

The path switching unit 44 includes:
a pulse control module 451, configured to control, by sending a pulse signal to the analog switch, the analog switch to switch the input paths to the solar power supply apparatus. For the specific implementation manner, refer to the description of the foregoing method embodiment.

In addition, the analog switch may further include another recharging path, where the recharging path is configured to recharge the battery. The terminal may further include:
a standby determining unit 46, configured to detect whether the terminal is in screen lock; upon detecting that the terminal screen is locked, determine that the terminal is in the standby state; and
a recharging path switching unit 47, configured to switch, when determining that the terminal is in the standby state, the solar power supply apparatus 41 through the analog switch 42 to another recharging path to supply power to the battery. For the specific implementation manner, refer to the description of the foregoing method embodiment.

The solar power supply apparatus may be formed by a solar panel and a photoelectric conversion module, and disposed on a rear side of the terminal. During the specific implementation process, the solar power supply apparatus may also be disposed in another position of the terminal; the solar panel and photoelectric conversion module may be implemented by common means in the prior art, which is not limited herein.

The module that matches the power supply voltage and solar input voltage may include one or more of the following: screen backlight module, keyboard backlight module, radio frequency PA module, motor module, and audio power effect module.

It should be noted that in the foregoing embodiment, all the included units are classified only according to the function logic, but are not limited to the classification method as long as the corresponding functions are able to be implemented. In addition, the names of all the function units are only used for distinguishing between each other, but are not configured to limit the protection scope.

In addition, a person of ordinary skill in the art may understand that all or part of the steps in the method embodiments may be implemented by a computer program instructing related hardware. The program may be stored in a computer readable storage medium. The storage medium may include a read-only memory, a magnetic disk, and an optical disc, which is able to be read by a computer.

In summary, the embodiments of the present invention are able to implement 7 ultra-long standby for a terminal by using solar energy, thereby significantly improving user experience.

The foregoing descriptions are merely preferred specific embodiments of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention is subject to the appended claims.

## Claims

1. An ultra-long standby method, comprising:
disposing a solar power supply apparatus on a terminal and disposing an analog switch between the solar power supply apparatus and a battery within the terminal, wherein the solar power supply apparatus and the battery form two input paths of an output circuit, the output circuit supplies power to a preset module, and the preset module is a module that matches a power supply voltage and a solar input voltage;
detecting whether or not the solar power supply apparatus continues to convert electrical energy; and
upon detecting that the solar power supply apparatus continues to convert electrical energy, controlling the analog switch to switch the input paths to the solar power supply apparatus so that the solar power supply apparatus supplies power to the preset module.

2. The ultra-long standby method according to claim 1, wherein the controlling the analog switch to switch the input paths to the solar power supply apparatus comprises:
by sending a pulse signal to the analog switch, controlling the analog switch to switch the input paths to the solar power supply apparatus.

3. The ultra-long standby method according to claim 1, further comprising:
detecting whether the terminal is in screen lock; upon detecting that the terminal screen is locked, determining that the terminal is in a standby state; and
switching the solar power supply apparatus through the analog switch to another recharging path to supply power to the battery.

4. An ultra-long standby terminal, comprising:
a solar power supply apparatus disposed on a terminal, configured to supply power to a terminal module that matches a power supply voltage and a solar input voltage;
an analog switch, disposed between the solar power supply apparatus and a battery within the terminal; wherein, the solar power supply apparatus and the battery form two input paths of an output circuit, the output circuit supplies power to a preset module in the terminal, and the preset module is a module that matches a power supply voltage and a solar input voltage;
a detecting unit, configured to detect whether or not the solar power supply apparatus continues to convert electrical energy; and
a path switching unit, configured to control, when the detecting unit detects that the solar power supply apparatus continues to convert electrical energy, the analog switch to switch the input paths to the solar power supply apparatus so that the solar power supply apparatus supplies power to the preset module.

5. The ultra-long standby terminal according to claim 4, wherein the path switching unit comprises:
a pulse control module, configured to control, by sending a pulse signal to the analog switch, the analog switch to switch the input paths to the solar power supply apparatus.

6. The ultra-long standby terminal according to claim 4, wherein the analog switch further comprises another recharging path, the recharging path is configured to recharge the battery, and the terminal further comprises:
a standby determining unit, configured to detect whether the terminal is in screen lock; upon detecting that the terminal screen is locked, determine that the terminal is in a standby state; and
a recharging path switching unit, configured to switch, when determining that the terminal is in the standby state, the solar power supply apparatus through the analog switch to the another recharging path to supply power to the battery.

7. The ultra-long standby terminal according to any one of claims 4 to 6, wherein:
the terminal comprises: a mobile phone, a tablet computer, or a laptop computer.

8. The ultra-long standby terminal according to claim 4, wherein:
the solar power supply apparatus is formed by a solar panel and a photoelectric conversion module, and disposed on a rear side of the terminal.

9. The ultra-long standby terminal according to claim 4, wherein the preset module may comprise one or more of the following:
screen backlight module, keyboard backlight module, radio frequency PA module, motor module, and audio power effect module.
